# EUROPÄISCHE PATENTANMELDUNG

(11) **EP 1 765 048 A2**
(43) Veröffentlichungstag der Anmeldung: **21.03.2007**
(21) Anmeldenummer: 06014986.1
(22) Anmeldetag: 19.07.2006
(51) Int. Cl.: H05K 5/00, H05K 7/14

(54) **Gehäuse, insbesondere Kunststoffgehäuse, mit einem Halter und einem Kontaktelement**

(30) Priorität: 15.09.2005 DE 102005044059
(71) Anmelder: Hirschmann Car Communication GmbH, 72654 Neckartenzlingen (DE)
(72) Erfinder: Merhazion, Kiflom, 72654 Neckartenzlingen (DE); Lipka, Günter, 73779 Deizisau (DE); Häußler, Helmut, 72631 Aichtal (DE)
(74) Vertreter: Thul, Hermann

(57) **Zusammenfassung**

Die Erfindung betrifft ein Gehäuse, insbesondere Kunststoffgehäuse, zur Aufnahme von auf zumindest einer Leiterplatte (15) angeordneten elektrischen und/oder elektronischen Bauteile, an die mittels Anschlüssen und Öffnungen im Gehäuse Leitungen anschließbar sind, wobei das Gehäuse eine Schale (1) und einen Deckel (11) aufweist, die miteinander mittels lösbarer Befestigungselemente verschließbar sind, wobei erfindungsgemäß vorgesehen ist, dass die Schale (1) und/oder der Deckel (11) eine Aussparung zur Aufnahme eines Halters (14) aufweist, mit dem das Gehäuse an einem Karosserieteil eines Fahrzeuges befestigbar sowie elektrisch kontaktierbar ist und innerhalb des Gehäuses ein Kontaktelement vorgesehen ist, welches einen elektrisch leitfähigen Bereich auf der Leiterplatte (15) mit dem Halter (14) kontaktiert.

## Beschreibung

Die Erfindung betrifft ein Gehäuse, insbesondere Kunststoffgehäuse, zur Aufnahme von auf zumindest einer Leiterplatte angeordneten elektrischen und/oder elektronischen Bauteilen gemäss den Merkmalen des Oberbegriffes des Patentanspruches 1.

Solche Gehäuse sind grundsätzlich bekannt. Nach Herstellung der Gehäuseteile wird die zumindest eine Leiterplatte, auf der die zur Realisierung der Funktion des elektronischen Gerätes erforderlichen Bauteile angeordnet sind, in dem Gehäuse untergebracht und dieses zum Beispiel an einem Karosserieteil eines Fahrzeuges montiert. Hierzu sind separate Befestigungsteile vorhanden, die an einem Gehäuseteil angeformt sind und mit denen das Gehäuse an dem Karosserieteil festgeschraubt wird. Über Steckverbindungen erfolgt dann die Stromversorgung, der Signalaustausch sowie gegebenenfalls eine Masseverbindung zwecks Abschirmung, insbesondere dann, wenn in dem Gehäuse ein hochfrequenztechnisch arbeitendes elektronisches Gerät untergebracht ist. Das bedeutet, dass mehrere Montageschritte erforderlich sind, nämlich zum einen die Kontaktierung des in dem Gehäuse untergebrachten elektronischen Gerätes über Steckverbindungen und dessen Montage an dem Karosserieteil des Fahrzeuges. Diese voneinander getrennten Montageschritte sind daher in nachteiliger Weise aufwändig.

Der Erfindung liegt daher die Aufgabe zu Grunde, ein Gehäuse zur Verfügung zu stellen bzw. so zu verbessern, dass mit geringem Aufwand seine Montage an einem Karosserieteil eines Fahrzeuges möglich ist.

Diese Aufgabe ist durch die Merkmale des Patentanspruches 1 gelöst.

Erfindungsgemäß ist vorgesehen, dass die Schale und/oder der Deckel eine Aussparung zur Aufnahme eines Halters aufweisen, mit dem das Gehäuse an einem Karosserieteil des Fahrzeuges befestigbar sowie elektrisch kontaktierbar ist und innerhalb des Gehäuses ein Kontaktelement vorgesehen ist, welches einen elektrisch leitfähigen Bereich auf der Leiterplatte mit dem Halter kontaktiert. Durch die Aussparung in dem Deckel und/oder der Schale kann der Halter aus einem zumindest teilweise, insbesondere vollständig elektrisch leitfähigen Material, insbesondere Metall, herausgeführt werden, wozu er innerhalb des Gehäuses an diesem mechanisch festgelegt ist und mit seinem nach außen abstehenden Teil an dem Karosserieteil befestigt, insbesondere verschraubt, werden kann. Dadurch wird auf der einen Seite die an sich bekannte Befestigung des Gehäuses an dem Karosserieteil, beispielsweise die Verschraubung, beibehalten, da sich diese Befestigung in der Praxis, insbesondere im Hinblick auf die Dauerhaltbarkeit, bewährt hat. Außerdem ist nach wie vor mittels des Halters eine große Freiheit gegeben, das elektronische Gerät, das in dem Gehäuse untergebracht ist, an der jeweils erforderlichen Stelle innerhalb des Fahrzeuges an dessen Karosserieteil zu befestigen. Gleichzeitig ist der Halter innerhalb des Gehäuses dort nicht nur mechanisch fixiert, sondern übernimmt auch elektrische Eigenschaften, indem nämlich über ein Kontaktelement der Halter mit einem elektrisch leitfähigen Bereich der Leiterplatte kontaktiert wird. Dies vereinfacht zunächst die Montage, da nach dem Einsetzen der Leiterplatte in das Gehäuse das Kontaktelement einen leitfähigen Bereich auf der Leiterplatte, insbesondere eine Kontaktfläche, mit dem Halter elektrisch kontaktiert. Das bedeutet, dass der Halter nicht nur der Montage, sondern auch der elektrischen Kontaktierung dient, insbesondere kann hierüber auf einfache Art und Weise eine Masseverbindung zwecks Abschirmung und/oder Stromversorgung hergestellt werden. Die Montage ist besonders einfach, wenn das Kontaktelement fest mit dem elektrisch leitfähigen Bereich auf der Leiterplatte oder fest mit dem Halter verbunden ist. Hier sind verschiedene Varianten denkbar. So kann beispielsweise einmal das Kontaktelement als Kontaktfeder ausgebildet sein, die fest mit dem elektrisch leitfähigen Bereich auf der Leiterplatte verbunden ist, insbesondere verlötet ist. Gleiches gilt für die Anordnung des Kontaktelementes bzw. der Kontaktfeder an einem Kontaktabschnitt des Halters, wozu dort das Kontaktelement, insbesondere die Kontaktfeder, an diesem Befestigungsabschnitt fest verbunden, insbesondere angelötet ist oder von dem Halter selber gebildet wird. Hier ist es beispielsweise auf einfache Art und Weise möglich, den Halter in einem Stanzbiegeverfahren herzustellen und zum Beispiel an seinem einen Ende (Kontaktabschnitt) das Kontaktelement anzuformen. Alternativ oder ergänzend dazu ist es möglich, ein Kontaktelement sowohl an dem elektrisch leitfähigen Bereich auf der Leiterplatte als auch ausgehend von dem Halter vorzusehen, die nach der Montage der Leiterplatte in dem Gehäuse gegenseitig zur Anlage kommen. Daneben ist es alternativ oder ergänzend denkbar, zwischen dem elektrisch leitfähigen Bereich auf der Leiterplatte und dem Kontaktabschnitt des Halters ein zusätzliches Kontaktelement einzusetzen. Dieses Kontaktelement kann ebenfalls eine Kontaktfeder sein, hierbei kann es sich aber auch um ein elastisch verformbares Kontaktelement handeln, welches zumindest teilweise, insbesondere vollständig aus einem elektrisch leitfähigen und elastisch verformbaren Material besteht (Kunststoffpad).

In einer besonderen Ausgestaltung der Erfindung ist die Kontaktfeder als Lamellenfeder ausgebildet, die zwischen dem elektrisch leitfähigen Bereich auf der Leiterplatte und dem Kontaktabschnitt des Halters einsetzbar ist. Das Gehäuseteil kann zur Aufnahme der lamellenartig ausgebildeten Kontaktfeder ausgebildet sein, so dass nach Vormontage dieses Kontaktelementes und anschließender Montage von Halter und Leiterplatte in dem Gehäuse die Kontaktierung erfolgt. Daneben ist es auch möglich, das lamellenartig ausgebildete Kontaktelement schon vorab an den Halter und/oder der Leiterplatte festzulegen. Als Beispiel für die lamellenartige Ausgestaltung der Kontaktfeder sei beispielhaft auf die DE 102 58 101 oder DE 103 47 917 verwiesen.

Vorteilhaft ist, dass der Halter auch erst nach der Leiterplattenmontage in das Gehäuse eingeschoben und verrastet werden kann. Dadurch sind während des Montagevorganges keine abstehenden und störenden Laschen vorhanden. Dadurch können die Module auch in großer Stückzahl vorproduziert und erst vor der Auslieferung mit einem kundenspezifischen Halter bestückt werden. Dies reduziert die Kosten in der Fertigung, der Fertigungseinrichtungen (einheitliche Transportaufnahme) und in der Lagerhaltung. Ein weiterer Vorteil ist darin begründet, dass der Halter einfach ausgetauscht werden kann.

Von besonderem Vorteil ist die Anwendung des erfindungsgemäßen Gehäuses in der Automobiltechnik, um die Montage zu vereinfachen und zu beschleunigen. In einem solchen Gehäuse können dann Antennenverstärker, Anpassungselemente, Summationselemente (wenn zum Beispiel zwei Antennen zusammengeschaltet werden), Empfänger für Radio- und/oder Fernsehsignale (Tuner), Diversityeinrichtungen und dergleichen untergebracht werden. Neben diesen Signalverarbeitenden Einrichtungen bietet es sich auch an, dass Sensoren, Aktoren, Steuergeräte und dergleichen untergebracht werden, die in Fahrzeugen eingebaut werden.

Ein Ausführungsbeispiel der Erfindung, dargestellt an unterschiedlichen Ausgestaltungen eines Gehäuses, ist im Folgenden beschrieben und in den Figuren gezeigt, ohne dass die Erfindung auf diese Ausführungsbeispiele beschränkt ist.

Es zeigen:
- Figur 1:: eine perspektivische Ansicht eines Gehäuses im geschlossenen Zustand,
- Figur 2:: eine perspektivische Ansicht einer Schale und eines Deckels des Gehäuses als Einzelbauteile,
- Figur 3:: eine perspektivische Ansicht der Schale und des Deckels bei der Montage der Bauteile,
- Figur 4:: eine perspektivische Ansicht der Schale und des Deckels entsprechend Figur 3, bei der allerdings die Schale und der Deckel bezüglich der Befestigungselemente modifiziert sind,
- Figur 5:: eine perspektivische Ansicht einer Schale und eines Deckels mit einem beispielhaften Halter zum Verschrauben,
- Figur 6:: eine perspektivische Ansicht einer Schale und eines Deckels mit einem Halter an einer anderen Stelle in die Schale,
- Figur 7:: eine perspektivische Ansicht einer Schale und eines Deckels mit einer dazwischen einsetzbaren Leiterplatte,
- Figur 8:: eine perspektivische Ansicht einer Schale und eines Deckels mit einer an dem Deckel befestigten Leiterplatte,
- Figur 9:: einen Schnitt durch das Gehäuse nach dem Zusammenbau.

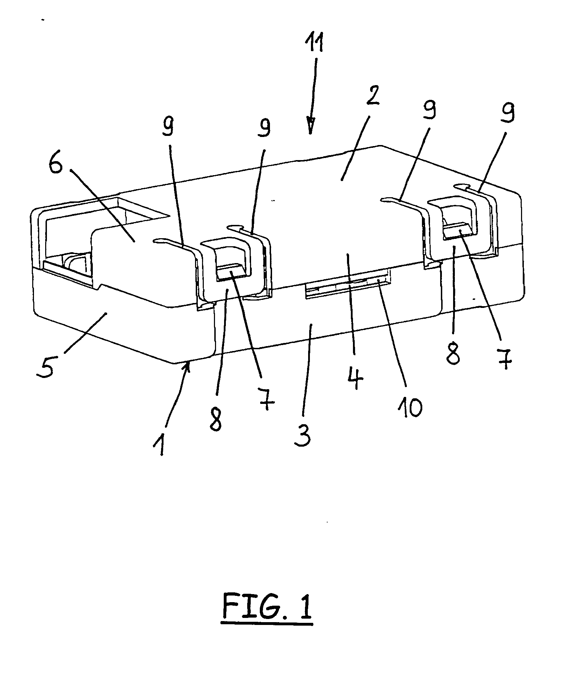

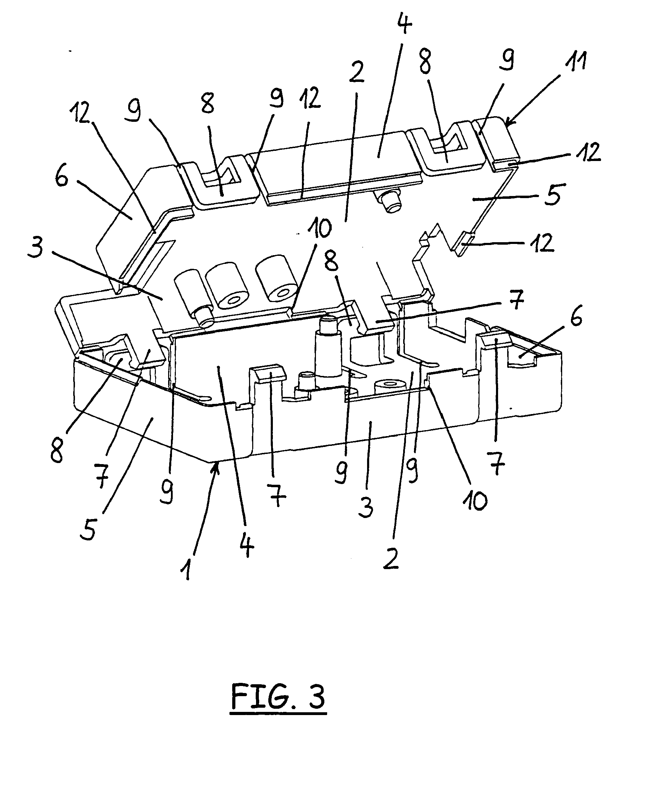

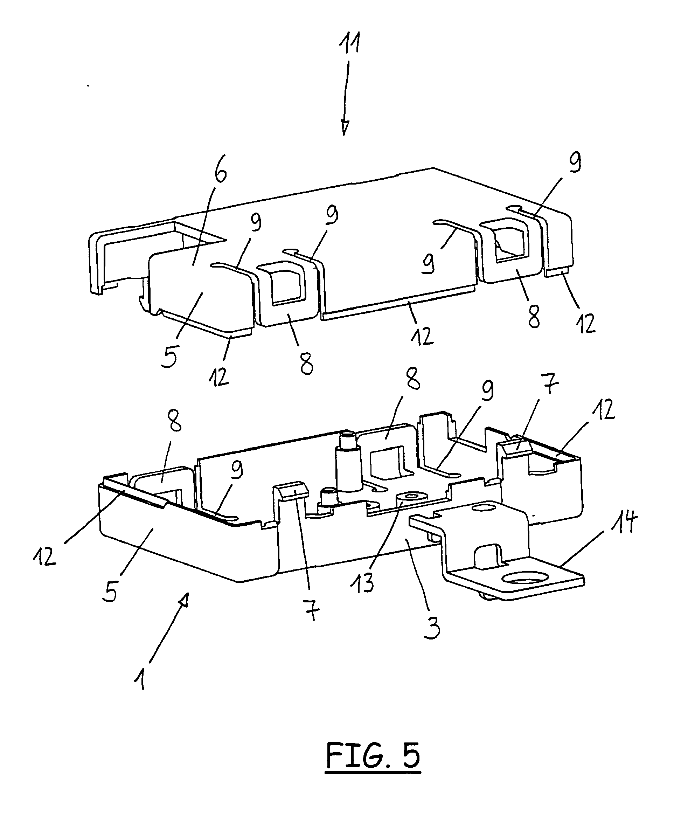

In den Figuren 1 bis 9 ist, soweit im Einzelnen dargestellt, mit der Bezugsziffer 1 eine Schale bezeichnet, die einen ebenen Boden 2 und rechtwinklig dazu ausgerichtete Seitenwände 3, 4, 5 und 6 aufweist. An der Seitenwand 3 der Schale 1 sind Haken 7 angebracht, die in Verlängerung der Seitenwand vorstehen und nach innen versetzt sind. An der gegenüberliegenden Seitenwand 4 der Schale 1 sind Ösen 8 angebracht, die in der Ebene der Seitenwand 4 angeordnet sind. Sie sind durch Einschnitte 9 in der Seitenwand 4 und im ebenen Boden 2 von der Seitenwand und dem Boden getrennt, so dass sie elastisch verbogen werden können. Die Öffnungen der Ösen 8 sind nicht nur in der Seitenwand 4 sondern über die Seitenwand hinaus bis in den ebenen Boden 2 geführt, so dass einerseits eine hohe Elastizität der Ösen 8 gegeben ist und andererseits ein hinreichender Raum für die Bauteile des Werkzeuges geschaffen wird, mit dem die Schale 1 hergestellt wird. In der Seitenwand 3 der Schale 1 ist weiterhin eine mit 10 bezeichnete Aussparung eingearbeitet, in die ein Halter eingeführt werden kann, der die Schale 1 an einem Bauteil eines Fahrzeuges befestigt. Mit der Bezugsziffer 13 sind die auf dem Gehäusegrund angebrachten (angespritzten) Halteraufnahmen zur Verschraubung oder Verrastung eines Halters 14 (siehe Figur 5) dargestellt. Es kann auch nur eine Öffnung im Deckel 11 oder in der Schale 1 sowie nur eine Halteraufnahme 13 vorhanden sein.

Die Schale 1 ist in Figur 1 von einem Deckel 11 verschlossen, der bezüglich der Befestigungselemente identisch ausgebildet ist, so dass die Bezugszeichen 2 bis 10 entsprechend verwendet werden.

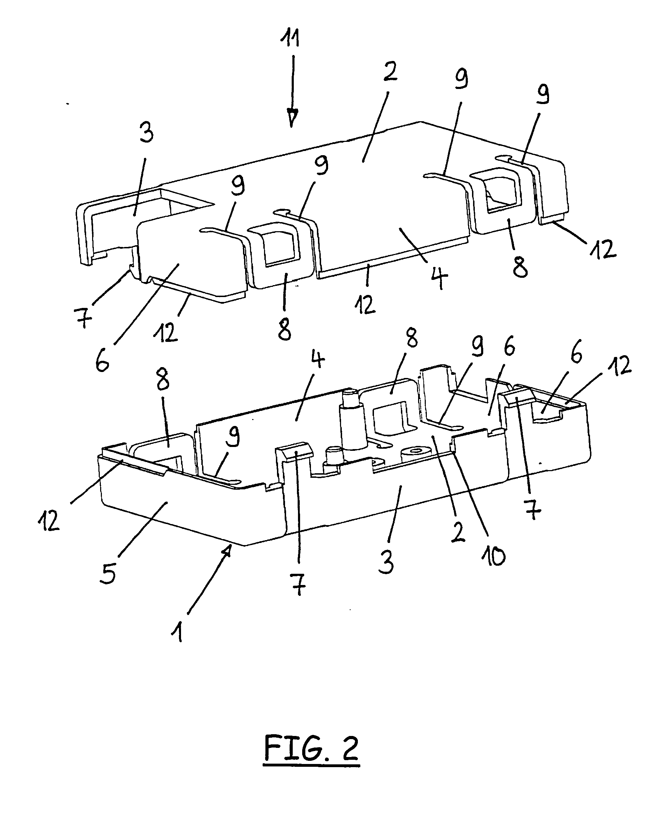

Wie insbesondere aus den Figuren 2 bis 4 ersichtlich, weisen die Ränder der Seitenwände 3 bis 6 Ausnehmungen 12 auf, die im Bereich der Ösen 8 im äußeren Bereich angebracht sind, während sie im Bereich der Haken 7 innen an den Rändern angeformt sind. Selbstverständlich ist dies auch umgekehrt ausführbar. Auch diese Aussparungen 12 sind spiegelbildlich sowohl an der Schale 1 als auch an dem Deckel 11 angebracht, so dass die Form sowohl der Schale 1 als auch des Deckels 11, abgesehen von Öffnungen im Gehäuse für Anschlüsse und Leitungen identisch ausgebildet ist.

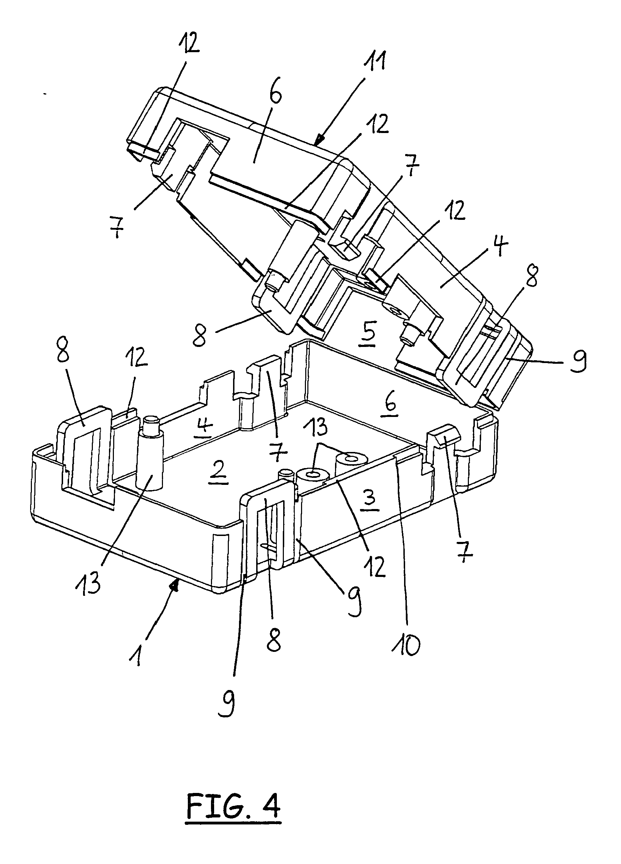

Die Ausgestaltung der Schale 1 und des Deckels 11 in Figur 4 unterscheidet sich dadurch von der Ausgestaltung gemäß den Figuren 1 bis 3, dass die Ösen 8 in den Seitenwand 3 und 4 der Seitenwand 5 benachbart angebracht sind, während die Haken 7 in den Seitenwänden 3 und 4 der Seitenwand 6 benachbart angeordnet sind. Diese Anordnung kann ebenso auch in diagonaler Ausrichtung erfolgen.

In Figur 4 ist dargestellt, dass sich die Ösen 8 dadurch von den in den Figuren 1 bis 3 dargestellten Ösen unterscheiden, dass sie länger ausgeführt sind und die Ränder der Seitenwände 3 und 4 überragen, während die Haken 7 in den Seitenwänden 3 und 4 in Aussparungen angebracht sind und in etwa mit den Rändern der Seitenwände 3 und 4 enden. Die Aussparungen 12 sind im Bereich der Haken 7 und der Seitenwand 6 außen angebracht, während sie im Bereich der Ösen 8 und der Seitenwand 5 innen angeformt sind.

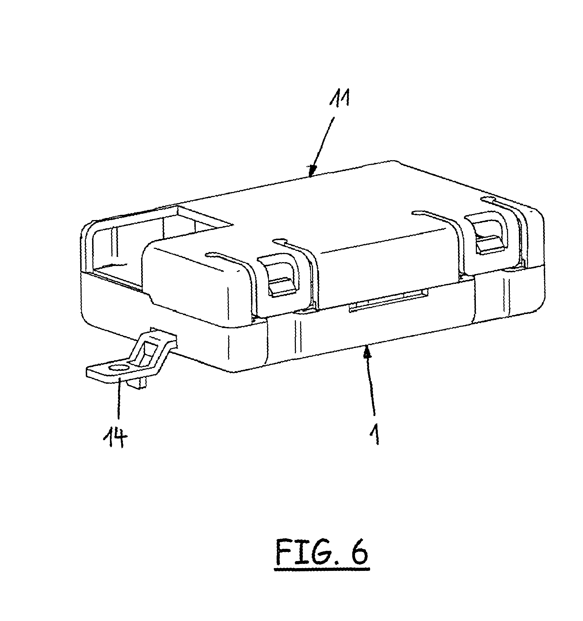

Während in Figur 5 dargestellt ist, dass der Halter an der Längsseite der Schale 1 angeordnet ist und nur diese eine Aussparung aufweist, zeigt Figur 6 als mögliche Alternative die Anordnung des Halters 14 an der Stirnseite der Schale 1. Daneben ist es selbstverständlich auch denkbar, dass der Halter 14 andere als die gezeigten Formen aufweist und auch an anderen Stellen aus dem Gehäuse herausgeführt ist. Gleiches gilt für die Aussparungen, durch die der Halter 14 in das Gehäuse (Schale 1 mit aufgesetztem Deckel 11) durchgeführt wird. Eine solche Aussparung kann entweder nur in der Schale 1 oder nur in dem Deckel 11 vorhanden sein (wie in den Figuren gezeigt), kann aber auch teilweise von der Schale 1 und teilweise von dem Deckel 11 gebildet werden.

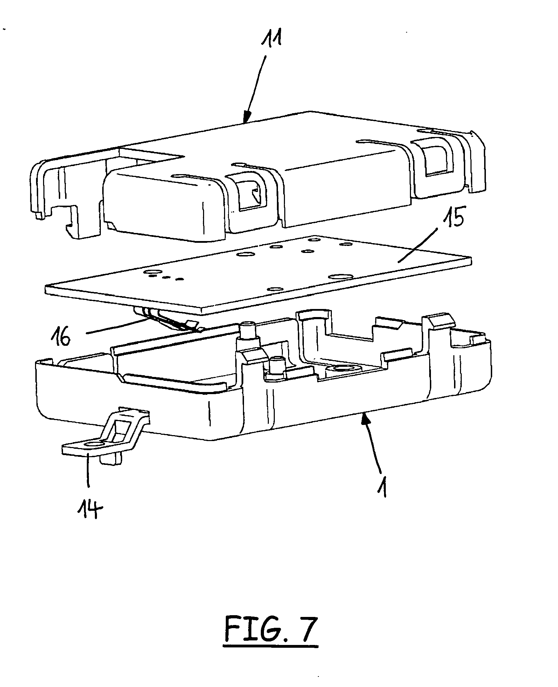

Figur 7 zeigt eine perspektivische Ansicht einer Schale und eines Deckels mit einer dazwischen einsetzbaren Leiterplatte. Hier ist erkennbar, dass die beiden Gehäuseteile 1, 11 zur Aufnahme zumindest einer Leiterplatte 15 ausgebildet sind, wobei die elektrischen und/oder elektronischen Bauteile sowie Steckverbindungen und dergleichen, die zwangsweise erforderlich sind, zur Vereinfachung der Darstellung hier weggelassen worden sind. Es ist lediglich dargestellt, dass an der Unterseite der Leiterplatte 15 eine Kontaktfeder 16 vorhanden ist, die mit einem elektrisch leitfähigen Bereich auf der Leiterplatte 15 (Leiterbahn) fest verbunden (verlötet) ist. Bei dieser Ausgestaltung weist die Kontaktfeder 16 ein freistehendes Ende auf, welches nach dem Einsetzen der Leiterplatte 15 und dem Zusammenfügen der Gehäuseteile 1, 11 mit dem Halter 14 kontaktiert wird.

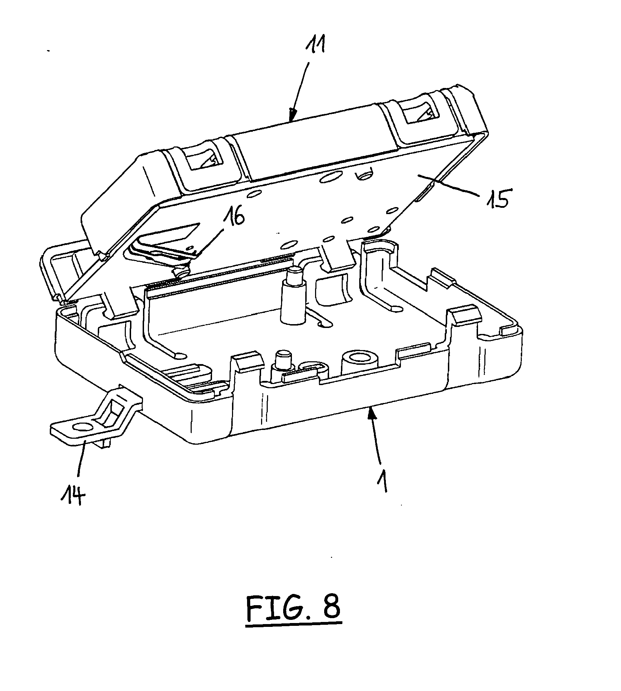

Figur 8 zeigt eine perspektivische Ansicht einer Schale und eines Deckels mit einer an dem Deckel befestigten Leiterplatte. Hier ist erkennbar, dass die Leiterplatte 15 zum Beispiel in dem Deckel 11 festgelegt wird, der dann mit der Schale 1 verbunden werden kann. Die Einheit aus Deckel 11 und eingesetzter Leiterplatte 15 lässt sich einfach vormontieren, so dass diese vormontierte Einheit ohne großen Montageaufwand aufgrund der Befestigungselemente an Schale 1 und Deckel 11 leicht montierbar ist.

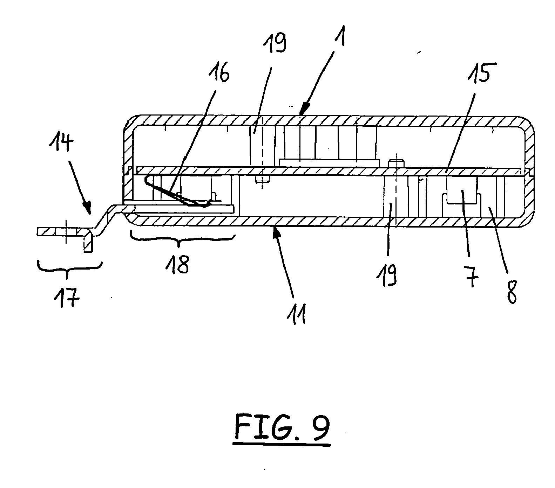

Figur 9 zeigt einen Schnitt durch das Gehäuse nach dem Zusammenbau, wobei erkennbar ist, dass die beiden Gehäuseteile 1, 11 unter Zwischenlegung der Leiterplatte 15 über die Befestigungselemente 7, 8 zusammengefügt worden sind. In dieser Figur 9 ist auch die Doppelfunktion des Halters 14 sehr gut erkennbar. Er weist einen außerhalb des Gehäuses angeordneten Befestigungsabschnitt 17 auf, mit dem das Gehäuse an dem Karosserieteil des Fahrzeuges befestigt, insbesondere angeschraubt werden kann. Innerhalb des Gehäuses hat der Halter 14 einen Kontaktabschnitt 18, mit dem er einerseits mechanisch innerhalb des Gehäuses fixiert wird (insbesondere über die Halteaufnahmen 13 mittels einer Verschraubung) und andererseits die elektrische Kontaktierung zwischen dem Halter 14 und der Kontaktfeder 16 erfolgt. Dadurch wird eine elektrische Kontaktierung zwischen dem zugehörigen elektrisch leitfähigen Bereich auf der Leiterplatte 15 über die Kontaktfeder 16 sowie den Kontaktabschnitt 18 und den Befestigungsabschnitt 17 des Halters mit dem Karosserieteil, vorzugsweise Masse, realisiert. Daneben ist es denkbar, dass das Gehäuse über den Halter 14 so mit einem Karosserieteil des Fahrzeuges verbunden wird und das Karosserieteil so entsprechend ausgebildet ist, dass nicht die Masse, sondern ein anderes elektrisches Potential kontaktiert wird. Die Leiterplatte 15 wird in dem Gehäuse über Dome 19 festgelegt, wobei diese Dome 19 an der Schale 1 und/oder an dem Deckel 11 vorhanden sind.

Insgesamt bietet also die Erfindung den Vorteil, dass das Gehäuse über den Halter 14 schnell und einfach und in bewährter Weise mechanisch festgelegt werden kann und gleichzeitig eine elektrische Kontaktierung gegeben ist. Während in den vorangegangenen Figuren und der zugehörigen Beschreibung davon ausgegangen worden ist, dass die Schale 1 und der Deckel 11 weitestgehend symmetrisch ausgebildet ist, ist es selbstverständlich auch denkbar, dass die beiden Teile 1, 11 unterschiedliche Formgebungen aufweisen können, im Zusammenspiel aber das fertige Gehäuse bilden.

### Bezugszeichenliste

- 1.: Schale
- 2.: Boden
- 3.: Seitenwand
- 4.: Seitenwand
- 5.: Seitenwand
- 6.: Seitenwand
- 7.: Haken
- 8.: Ösen
- 9.: Einschnitte
- 10.: Aussparungen
- 11.: Deckel
- 12.: Ausnehmungen
- 13.: Halteraufnahmen
- 14.: Halter
- 15.: Leiterplatte
- 16.: Kontaktfeder
- 17.: Befestigungsabschnitt
- 18.: Kontaktabschnitt
- 19.: Dome

## Patentansprüche

1. Gehäuse, insbesondere Kunststoffgehäuse, zur Aufnahme von auf zumindest einer Leiterplatte (15) angeordneten elektrischen und/oder elektronischen Bauteile, an die mittels Anschlüssen und Öffnungen im Gehäuse Leitungen anschließbar sind, wobei das Gehäuse eine Schale (1) und einen Deckel (11) aufweist, die miteinander mittels lösbarer Befestigungselemente verschließbar sind, **dadurch gekennzeichnet, dass** die Schale (1) und/oder der Deckel (11) eine Aussparung zur Aufnahme eines Halters (14) aufweist, mit dem das Gehäuse an einem Karosserieteil eines Fahrzeuges befestigbar sowie elektrisch kontaktierbar ist und innerhalb des Gehäuses ein Kontaktelement vorgesehen ist, welches einen elektrisch leitfähigen Bereich auf der Leiterplatte (15) mit dem Halter (14) kontaktiert.

2. Gehäuse nach Anspruch 1, **dadurch gekennzeichnet, dass** das Kontaktelement eine Kontaktfeder (16) ist.

3. Gehäuse nach Anspruch 1 oder 2, **dadurch gekennzeichnet, dass** das Kontaktelement bzw. die Kontaktfeder (16) zwischen dem elektrisch leitfähigen Bereich auf der Leiterplatte (15) und dem Halter (14) einsetzbar ist.

4. Gehäuse nach Anspruch 1 oder 2, **dadurch gekennzeichnet, dass** das Kontaktelement bzw. die Kontaktfeder (16) fest mit dem elektrisch leitfähigen Bereich auf der Leiterplatte (15) oder fest mit dem Halter (14) verbunden ist.

5. Gehäuse nach einem der vorhergehenden Ansprüche, **dadurch gekennzeichnet, dass** das Kontaktelement ein elastisch verformbares Kontaktelement aus einem zumindest teilweise elektrisch leitfähigen Material ist.

6. Gehäuse nach einem der vorhergehenden Ansprüche, **dadurch gekennzeichnet, dass** die Kontaktfeder (16) ein freistehendes Ende aufweist.

7. Gehäuse nach einem der vorhergehenden Ansprüche, **dadurch gekennzeichnet, dass** die Kontaktfeder (16) als Lamellenfeder ausgebildet ist.

8. Gehäuse nach einem der vorhergehenden Ansprüche, **dadurch gekennzeichnet, dass** der Halter erst am fertigen Gehäuse angeordnet wird.

9. Gehäuse nach einem der vorhergehenden Ansprüche, **dadurch gekennzeichnet, dass** der Halter auswechselbar am Gehäuse befestigbar ist.
